Europäisches Patentamt

European Patent Office

Office européen des brevets

(19)

(11) Publication number: **0 243 169 B1**

# EUROPEAN PATENT SPECIFICATION

(12)

(45) Date of publication of patent specification: **19.08.92**   (51) Int. Cl.⁵: **G11C 7/06**

(21) Application number: **87303533.1**

(22) Date of filing: **22.04.87**

(54) **Sense amplifiers.**

(30) Priority: **24.04.86 JP 93456/86**

(43) Date of publication of application:
**28.10.87 Bulletin 87/44**

(45) Publication of the grant of the patent:
**19.08.92 Bulletin 92/34**

(84) Designated Contracting States:
**AT DE FR GB IT NL**

(56) References cited:

**IEEE JOURNAL OF SOLID-STATE CIRCUITS,
vol. SC-14, no. 6, December 1979, pages
1066-1070; S. SUZUKI et al.: "Threshold dif-
ference compensated sense amplifier"**

**PATENT ABSTRACTS OF JAPAN, vol. 9, no.
24 (P-331), 31st January 1985; & JP-A-59 167
896 (TOSHIBA K.K.) 21-09-1984**

**PATENT ABSTRACTS OF JAPAN, vol. 5, no.
175 (P-88), 11st November 1981; & JP-A-56
105 389 (FUJITSU LTD) 21-08-1981**
(73) Proprietor: **SONY CORPORATION
7-35 Kitashinagawa 6-chome Shinagawa-ku
Tokyo 141(JP)**

(72) Inventor: **Soneda, Mitsuo
c/o P.D. Sony Corporation 6-7-35
Kitashinagawa
Shinagawa-ku Tokyo 141(JP)**

(74) Representative: **Cotter, Ivan John et al
D. YOUNG & CO. 10 Staple Inn
London WC1V 7RD(GB)**

## Description

This invention relates to sense amplifiers. Sense amplifiers embodying the invention may, for example, be used for amplifying sensed information signals appearing on bit lines from respective memory cells in a memory.

In computer systems, information processing systems and control systems, it is necessary to store digital data and to retrieve it as desired. In a semiconductor memory, an array of storage or memory cells or elements is used to store data, with each memory cell holding one bit of data. When information can be randomly put into or taken out of each memory cell as required, the array is called a random access memory (RAM) and may be a static RAM (SRAM) or a dynamic RAM (DRAM). The individual memory cells are addressed by data input and output lines, with each memory cell commonly having two output bit lines for indicating the presence of a "0" or "1" bit read out from the memory cell. The "0" and "1" bits are represented by different voltages which, when stored in the memory cells, may be quite small and may accumulate errors tending to reduce the difference between the respective voltages. Therefore, it is advantageous to include sense amplifiers which are connected to the output bit lines and which are operative to detect more accurately the voltages appearing on the bit lines and to latch the digital bit indicated thereby to provide a more accurate readout.

One advantageous example of such a sense amplifier includes cross-coupled field effect transistors each having a first current carrying electrode (source or drain electrode) coupled to a respective one of the bit lines and a gate electrode coupled to the other of the bit lines. Second current carrying electrodes (drain or source electrodes) of the transistors are coupled together to receive a control signal which permits or prevents turning on of the transistors. If, for example, NMOS transistors are used, each transistor will turn on when the difference between the gate voltage and the source voltage is greater than the threshold voltage of the transistor. The signal to be sensed appears on only one of the bit lines, which then carries a voltage higher or lower than the other bit line, depending on the value of the sensed signal. Consequently, when the control signal applied to the connected second current carrying electrodes is lowered to permit turning on of the two transistors, the transistor having its gate electrode coupled to the bit line carrying the higher voltage will turn on first. The other transistor will thereafter be maintained in its off state to latch the information read out from the memory cell.

However, the sensitivity of such a sense amplifier depends critically on the threshold voltage $V_{th}$ of each field effect transistor. If the threshold voltage of the transistor which is intended to turn on first becomes significantly larger than the threshold voltage of the other transistor, it may happen that the other transistor will turn on instead of the first transistor, resulting in an erroneous read operation. The threshold voltage of a field effect transistor varies in a known way with its channel length, and the development of VLSI integration and miniaturisation techniques has made the channel length shorter and shorter and the possible dispersion, or difference, in the threshold voltages correspondingly larger and larger. The resulting increased possibility of sensing errors is a significant limitation upon higher integration and miniaturisation.

An article by Shunichi Suzuki et al entitled "Threshold Difference Compensated Sense Amplifier", published in IEEE JOURNAL OF SOLID-STATE CIRCUITS, VOL. SC-14, NO. 6, DECEMBER 1979, discloses (Figure 2) a sense amplifier comprising:

first and second bit lines for receiving sensed signals;

first and second cross-coupled field effect transistors each having a gate electrode and first and second current carrying electrodes;

capacitive means for capacitively coupling the gate electrodes of the first and second transistors with the second and first bit lines, respectively;

first switching means for separably connecting the gate electrodes of the first and second transistors with the first current carrying electrodes of the first and second transistors, respectively; and

second switching means for separably connecting the first current carrying electrodes of the first and second transistors with the first and second bit lines, respectively;

the first and second switching means and the second current carrying electrodes of the first and second transistors being responsive to respective control signals for compensating the sense amplifier for any threshold voltage difference between the first and second transistors.

The present invention provides a sense amplifier as just set forth, characterised in that the second switching means is operable to connect the first current carrying electrodes of the first and second transistors directly (that is, not via the capacitive means, as in the case of the amplifier disclosed in the above-cited reference) to the first and second bit lines, respectively.

Accordingly, the invention provides a sense amplifier which compensates for threshold voltage differences of cross-coupled field effect transistors therein.

The present invention can be so embodied as to provide a sense amplifier which can reliably sense a read out signal in a highly miniaturized construction.

Preferably, the capacitive means precharges to voltages compensating for any dispersion between the threshold voltages of the first and second transistors during a precharging operation of the sense amplifier, carried out prior to a sensing operation of the sense amplifier, and then supplies the precharged voltages to the gate electrodes of the first and second transistors during the sensing operation.

The invention will now be further described, by way of illustrative and non-limiting example, with reference to the accompanying drawings, in which like references designate like items throughout, and in which:

Figure 1 is a circuit diagram of a sense amplifier according to a preferred embodiment of the present invention;

Figure 2 is a timing diagram used in explaining the operation of the sense amplifier of Figure 1;

Figure 3 is a circuit diagram of a previously proposed sense amplifier; and

Figure 4 is a timing diagram used in explaining the operation of the sense amplifier of Figure 3.

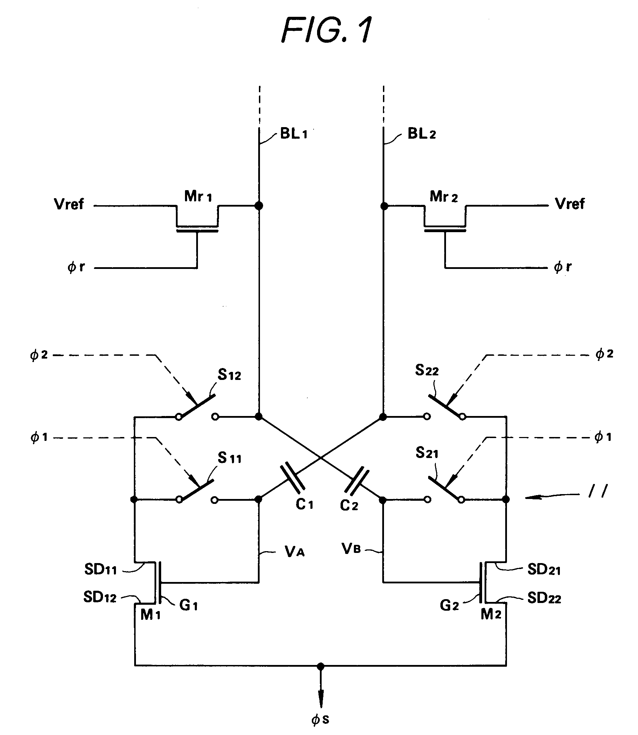

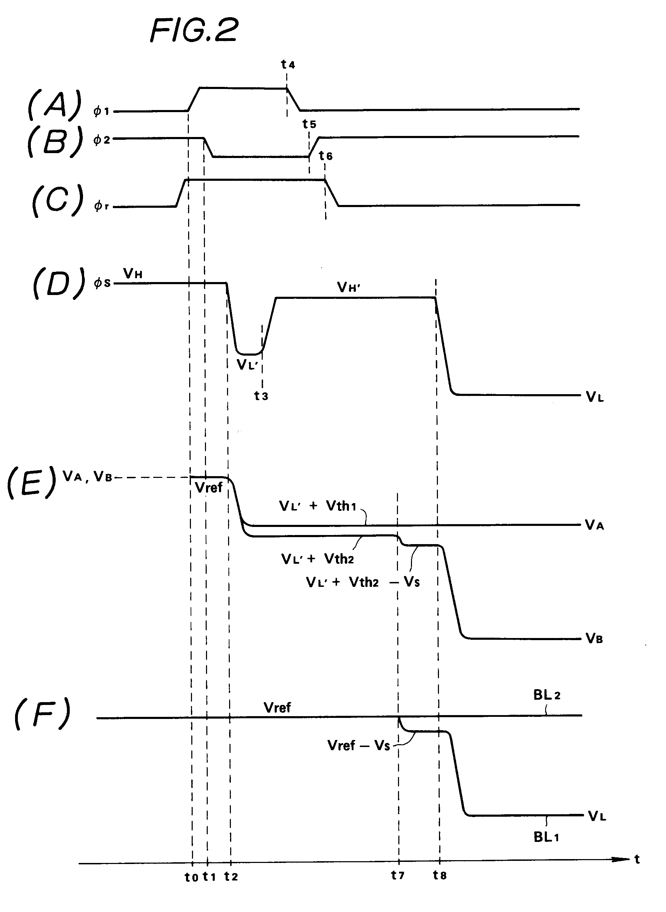

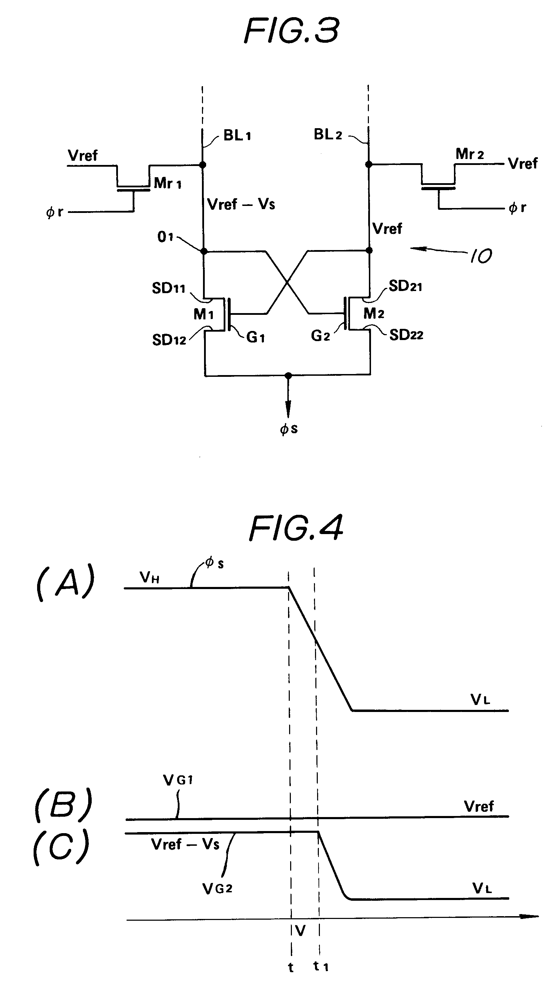

In order that purposes served by a sense amplifier embodying the present invention and described hereinbelow with reference to Figures 1 and 2 may be fully appreciated, a previously proposed sense amplifier 10 will first be described with reference to Figures 3 and 4. As shown in Figure 3, the previously proposed sense amplifier 10 has first and second field effect transistors (FETs) M1 and M2 which, in the illustrated example, are NMOS field effect transistors (n-channel FETs). Those skilled in the art will, however, appreciate that a corresponding sense amplifier could be constructed using PMOS field effect transistors (n-channel FETs) with appropriate changes in the control signals described below. The first transistor M1 has a first current carrying electrode SD11 connected to a first bit line BL1 extending from a memory cell (not illustrated). Correspondingly, the second transistor M2 has a first current carrying electrode SD21 connected to a second bit line BL2 extending from the memory cell. The transistors M1 and M2 also include second current carrying electrodes SD12 and SD22, respectively, which are connected together to receive a common control signal $\phi_s$. Since the transistors M1 and M2 are n-channel FETs, the first current carrying electrodes SD11, SD21 are the drain electrodes while the second current carrying electrodes SD12, SD22 are the source electrodes.

A gate electrode G1 of the transistor M1 is connected to the bit line BL2, while a gate electrode G2 of the transistor M2 is connected to the bit line BL1. A reference voltage $V_{ref}$ is supplied to the bit line BL1 through a control transistor Mr1 which is turned on and off in response to a control signal $\phi_r$. The reference voltage $V_{ref}$ is also supplied to the bit line BL2 through a second control transistor Mr2 similarly controlled by the control signal $\phi_r$. The control transistors Mr1 and Mr2 are advantageously constructed in the same technology as the transistors M1, M2, and thus in the present case are n-channel FETs.

The operation of the sense amplifier 10 shown in Figure 3 will now be described with reference to Figure 4, wherein an upper line A indicates the control signal $\phi_s$, a middle line B indicates a voltage $V_{G1}$ appearing at the gate electrode G1 of the transistor M1, and a lower line C indicates a voltage $V_{G2}$ appearing at the gate electrode G2 of the transistor M2. The control signal $\phi_r$ (not illustrated) is initially at a high level to maintain the transistors Mr1 and Mr2 in the on condition so that the reference volume $V_{ref}$ is impressed on both the bit lines BL1 and BL2. For the purpose of this example, assume that the bit to be read out of the memory cell is a digital "0" having a positive sense voltage $V_s$ and is impressed on the bit line BL1 as $V_{ref} - V_s$ in accordance with known principles. The sense amplifier 10 is provided for the purpose of sensing the sense voltage $V_s$ and outputting, for example at a junction $O_1$ shown in Figure 3, a low voltage $V_L$ which is equal to a standard voltage for a "0" bit in the particular system and which can be recognised as such by other circuit elements. Similarly, the sense amplifier 10 will output at the junction $O_1$ a high voltage $V_H$ equal to a standard voltage for a "1" bit in the particular system when a sense voltage $V_s$ indicating a stored "1" bit is read out from the memory cell and impressed on the bit line BL1 as $V_{ref} + V_s$, as discussed below.

As is well known, n-channel FETs such as the transistors M1 and M2 turn on only when $V_{GS} > V_{th}$, that is when the gate to source voltage $V_{GS}$, which is equal to the gate voltage $V_G$ minus the source voltage $V_S$, is greater than the threshold voltage $V_{th}$ of the respective transistor. The threshold voltage $V_{th}$ is a positive voltage for n-channel FETs, and may be in the range of 2 to 4 volts. Let it further be assumed initially for this example that the transistors M1 and M2 have the same threshold voltage $V_{th}$. Ideally, all transistors created on a silicon wafer during the same manufacturing process should have the same threshold voltage $V_{th}$, but in fact the individual threshold voltages $V_{th}$ vary over a range of values which can lead to sensing errors as discussed below.

Initially, as shown by the line A of Figure 4, the control signal $\phi_s$ is at the high voltage $V_H$ which is higher than the reference voltage $V_{ref}$. The voltage $V_{G1}$ (line B) is the voltage on the bit line BL2, that is $V_{ref}$, while the voltage $V_{G2}$ (line C) is the voltage on the bit line BL1, that is $V_{ref}$ - $V_s$. Consequently, the gate to source voltages $V_{GS1}$ and $V_{GS2}$ of the transistors M1 and M2, respectively, have the relationships

$$V_{GS1} = V_{G1} - \phi_s = V_{ref} - V_H < 0$$
$$V_{GS2} = V_{G2} - \phi_s = V_{ref} - V_s - V_H < 0$$

and both the transistors M1 and M2 are off.

Subsequently, at a time t, a sensing operation of the sense amplifier 10 is initiated and the control signal $\phi_s$ begins to decrease towards $V_L$. Shortly thereafter, at a time t1, the control signal $\phi_s$ will have dropped to a value where

$$V_{GS1} = V_{ref} - \phi_s > V_{th}$$

while

$$V_{GS2} = V_{ref} - V_s - \phi_s < V_{th}$$

so that the transistor M1 turns on first while the transistor M2 remains off. With the transistor M1 on, the current flows from the electrode SD11 to the electrode SD12 so that, as the control signal $\phi_s$ continues to decrease, the voltage on the bit line BL1 is pulled down to $V_L$, as shown by the line C of Figure 4. Moreover, since the voltage on the bit line BL1 is the gate voltage $V_{G2}$, both the gate voltage $V_{G2}$ and the source voltage $V(SD22) = \phi_s$ of the transistor M2 are pulled down together so that the gate to source voltage $V_{GS2}$ never exceeds $V_{th}$, and the transistor M2 remains off throughout the sensing operation. Consequently, the voltage on the bit line BL2 is not pulled down and stays at $V_{ref}$, so that the transistor M1 stays on. The results is that the digital bit "0" is latched in the sense amplifier 10 with the transistor M1 on and the transistor M2 off. This state may be sensed and the low voltage $V_L$ at the electrode SD11 connected to the junction $0_1$ may be taken out for supply to other circuit elements.

Correspondingly, when a digital "1" is read from the memory cell and impressed on the bit line BL1 as the voltage $V_{ref} + V_s$, the reduction of the control signal $\phi_s$ towards the voltage $V_L$ will cause the transistor M2 to turn on first, since

$$V_{GS2} = V_{G2} - \phi_s = V_{ref} + V_s - \phi_s > V_{GS1} = V_{ref} - \phi_s.$$

Now it is the voltage at the electrode SD21 which is pulled down because the transistor M2 is on, while the transistor M1 is held in the off state as its gate to source voltage $V_{GS1}$ never exceeds $V_{th}$. At the end of the sensing operation, the sense amplifier 10 now has the transistor M1 off and the transistor M2 on, which state is opposite to that when a digital "0" is read out of the memory cell.

The correct operation of the sense amplifier 10 is critically dependent on the values of the threshold voltages $V_{th}$ of the transistors M1 and M2 to ensure that the appropriate transistor will always be turned on first. When the two threshold voltages are equal, the read out sense voltage $V_s$ will be correctly sensed regardless of the value of the sense voltage $V_s$. However, with increasing miniaturisation and higher and higher integration, the channel length L of each FET becomes shorter and shorter and therefore the effect of small differences in the channel length L becomes more significant. The threshold voltage $V_{th}$ of each FET is dependent on the channel length L, and so the dispersion in threshold voltage is increased as the channel length L is decreased, increasing the risk of sensing errors and thereby limiting further miniaturisation.

In particular, using the example of sensing a digital "0", the transistor $M_1$ must always turn on before the transistor $M_2$ or, in other words, a condition for accurate and reliable sensing that the relationship

$$V_{GS2} - V_{th2} < V_{GS1} - V_{th1},$$

where $V_{th2}$ and $V_{th1}$ are the threshold voltages of the transistors M2 and M1, respectively, must always hold true. Since $V_{GS2} = V_{ref} - V_s - \phi_s$ and $V_{GS1} = V_{ref} - \phi_s$,
the reliable sensing condition can equivalently be expressed as

$$V_{ref} - V_s - V_{th2} < V_{ref} - V_{th1}$$

or

$$V_s > | V_{th1} - V_{th2} | = \Delta V_{th},$$

where $\Delta V_{th}$ is the dispersion of the threshold voltages (threshold dispersion voltage). With increasing miniaturisation, the threshold dispersion voltage $\Delta V_{th}$ increases as discussed above, while the sense voltage $V_s$, which is proportional to the electrical charge stored in the memory cell and read out therefrom, becomes smaller. Consequently, the likelihood of sensing errors becomes greater and greater and eventually becomes unacceptable.

The preferred embodiment of the present invention described hereinbelow with reference to Figures 1 and 2 eliminates or at least reduces sensing errors due to dispersion of the threshold voltage $V_{th}$ by compensating the gate voltages $V_{G1}$ and $V_{G2}$ applied to the gate electrodes G1 and G2 of the transistors M1 and M2. More particularly, the gate electrodes G1 and G2 and the bit lines BL2 and BL1 are respectively capacitively connected and a voltage corresponding to the threshold dispersion voltage $\Delta V_{th}$ is accumulated during a precharging operation prior to the sensing operation for compensating the transistors M1 and M2 to ensure a highly accurate and reliable sensing operation. To this end, as shown in Figure 1, during the precharging operation the field effect transistors M1 and M2 are placed in a common drain configuration so as effectively to operate as diodes, the capacitors C1 and C2 are connected between the gate electrodes G1 and G2 and the bit lines BL2 and BL1, respectively, and are charged through such "diodes" to respective precharged voltages. During the sensing operation, the transistors M1 and M2 are operative in the conventional (amplifying) sense or manner described above with reference to the circuit of Figure 3, but are compensated by the precharged voltages applied by the respective capacitors C1 and C2 to the gate electrodes G1, G2 to remove the effect of any threshold dispersion voltage $\Delta V_{th}$.

More particularly, during the precharging period when the transistors M1 and M2 are connected in the diode configuration, the voltage across the "diode" from the gate electrode G1 to the source electrode SD12 of the transistor M1 equals the threshold voltage $V_{th1}$, while the voltage across the "diode" from the gate electrode G2 to the source electrode SD22 of the transistor M2 equals the threshold voltage $V_{th2}$. The capacitors C1 and C2, coupled between these "diodes" and the respective bit lines receiving the reference voltage $V_{ref}$, therefore accumulate respective charges equal to the difference between the reference voltage $V_{ref}$ and the voltage of the control signal $\phi_s$ minus $V_{th1}$ and $V_{th2}$, respectively. Thereafter, when the transistors M1 and M2 are returned to their usual sense amplifying configuration, the difference between the two precharged voltages accumulated on the capacitors corresponds to the threshold dispersion voltage $\Delta V_{th} = |V_{th1} - V_{th2}|$, so that the sensing operation is compensated.

More specifically, as shown in Figure 1, a sense amplifier 11 according to a preferred embodiment of the present invention has the first capacitor C1 connected in series between the gate electrode G1 and the bit line BL2 and the second capacitor C2 connected in series between the gate electrode G2 and the bit line BL1. First switches S12 and S22 separably connect the drain electrode SD11 with the bit line BL1 and the drain electrodes SD21 with the bit line BL2, respectively, prior to the connections between the capacitors C2 and C1 and the bit lines BL1 and BL2 so that, when the switches S12 and S22 are open, the capacitors C1 and C2 are still connected with the bit lines BL2 and BL1. The first switches S12, S22 are ganged so as to open and close togther in response to a control

signal $\phi_2$.

The transistor M1 has its gate electrode G1 and its drain electrode SD11 separably connected by a switch S11 connected before the series connection of the gate electrode $G_1$ to the capacitor C1. Correspondingly, the transistor M2 has its gate electrode G2 separably connected to its drain electrode SD21 by a switch S21 connected before the series connection of the gate electrode G2 to the capacitor C2. The switches S11 and S21 are ganged so as to open and close together in response to a control signal $\phi_1$. When the switches S11 and S21 are closed, the gate and drain electrodes of the n-channel FETs M1 and M2 are connected in a common drain configuration and function equivalently to diodes with the forward voltage take from gate to source. The switches S11, S12, S21 and S22 may all be constructed as control transistors similar to the transistors Mr1 and Mr2, and are "open" when off and "closed" when on. It will be appreciated that, apart from the added capacitors C1 and C2 and switches S11, S12, S21 and S22, the sense amplifier 11 embodying the invention is similar to the previously proposed sense amplifier 10 described above with reference to Figures 3 and 4 and has its corresponding parts identified by the same references.

The operation of the sense amplifier 11 will now be described with reference to Figure 2. A voltage $V_A$ (line E in Figure 2) is the voltage at the junction or connection point between the capacitor C1 and the gate electrode G1, while a voltage $V_B$ - (line E in Figure 2) is the voltage at the junction between the capacitor C2 and the gate electrode G2. Prior to a time t0, that is prior to the precharging operation of the sense amplifier 11, the control signal $\phi_1$ (line A in Figure 2) is at a low level to open the switches S11 and S21, the control signal $\phi_2$ (line B in Figure 2) is at a high level to close the switches S12 and S22, the control signal $\phi_s$ (line D in Figure 2) is at the high voltage $V_H$ so that the transistors M1 and M2 are off, and the control signal $\phi_r$ (line C in Figure 2) is at a low level to turn off the control transistors Mr1 and Mr2. As the control signal $\phi_r$ rises to its high level, it turns on the control transistors Mr1 and Mr2 to supply the reference voltage $V_{ref}$ to the bit lines BL1 and BL2 (line F in Figure 2). Since the transistors M1 and M2 remain off, the voltages $V_A$ and $V_B$ are undefined at this time. Thereafter, at the time t0, to start the precharging operation, the control signal $\phi_1$ goes to its high level from its low level to close the switches S11 and S21 and thereby connect the gate electrodes G1 and G2 to the bit lines BL1 and BL2, through the closed switches S12, S22, respectively. Consequently, the voltages $V_A$ and $V_B$ both go to the reference voltage $V_{ref}$.

At a time t1, the control signal $\phi_2$ goes from its

high level to its low level, opening the switches S12 and S22 to break the connection between the drain electrodes SD11 and SD21 and the bit lines BL1 and BL2, respectively. This puts the transistors M1 and M2 into their diode configurations, so that they operate equivalently to diodes connected in series with the capacitors C1 and C2, respectively. Since the voltages on the bit lines BL1 and BL2 and the voltages $V_A$ and $V_B$ are all at the level of the references voltage $V_{ref}$, the capacitors C1 and C2 do not charge. Since the control signal $\phi_s$ is still at the high level voltage $V_H$ which is greater than the reference voltage $V_{ref}$, the "diodes" are reverse biased and no current flows.

At a time t2, the control signal $\phi_s$ is reduced to an intermediate low voltage $V_L'$ which is higher than the low voltage $V_L$ but lower than the reference voltage $V_{ref}$ so as to permit the "diodes" to be forward biased. Consequently, voltages corresponding to the threshold voltages $V_{th1}$ and $V_{th2}$ of the transistors M1 and M2, respectively, are applied to the capacitors C1 and C2. In particular, the voltage $V_A$ at the gate electrode G1 goes to a voltage $V_L' + V_{th1}$, that is the voltage $V_L'$ at the anode of the "diode" plus the diode voltage $V_{th1}$. Correspondingly, the voltage $V_B$ at the gate electrode G2 goes to $V_L' + V_{th2}$. Consequently, the voltage difference $V_{C1}$ between the voltage $V_A$ at one terminal of the capacitor C1 and the voltage $V_{ref}$ at the bit line BL2 at the other terminal of the capacitor C1, that is the voltage to which capacitor C1 precharges, is given by

$$V_{C1} = V_{ref} - (V_L' + V_{th1}).$$

Correspondingly, the voltage difference $V_{C2}$ across the two terminals of the capacitor C2, that is the voltage to which the capacitor C2 precharges, is given by

$$V_{C2} = V_{ref} - (V_L' + V_{th2}).$$

As is readily apparent, the magnitude of the difference between the two precharged voltages $V_{C1}$ and $V_{C2}$ is $| V_{th1} - V_{th2} |$, that is the dispersion threshold voltage $\Delta V_{th}$.

At a time t3, the control signal $\phi_s$ is changed from $V_L'$ to an intermediate high voltage level $V_H'$ slightly lower than the high voltage $V_H$. This temporarily reverse biases the "diodes" while the switches S11, S21 are opened and the switches S12 and S22 are closed, as discussed below, to prevent any noise spikes generated by the opening and closing of these switches from discharging the capacitors C1, C2. If noise spikes are otherwise removed from the circuit, this change in the control signal $\phi_s$ is unnecessary.

At a time t4, the control signal $\phi_1$ goes from

its high level to its low level to open the switches S11 and S21 so as to disconnect the gate electrode G1 from the drain electrode SD11 of the transistor M1 and the gate electrode G2 from the drain electrode SD21 of the transistor M2, respectively. The transistors M1 and M2 are no longer in their diode configuration and return to conventional transistor operation.

At a time t5, the control signal $\phi_2$ goes from its low level to its high level to again close the switches S12 and S22 for connecting the drain electrode SD11 of the transistor M1 to the bit line BL1 and connecting the drain electrode SD21 of the transistor M2 to the bit line BL2. The sense amplifier 11 is now configured identically to the sense amplifier 10 of Figure 3 except for the presence of the capacitors C1 and C2 carrying the precharged voltages $V_{C1}$ and $V_{C2}$, respectively.

At a time t6, the control signal $\phi_r$ goes from its high level to its low level to turn off the control transistors Mr1 and Mr2 and to cut off the supply of the reference voltage $V_{ref}$ to the bit lines BL1 and BL2. During the period from t3, through t6, up to the start of a sensing operation at a time t7, the precharged voltages $VC1 = V_{ref} - (V_L' + V_{th1})$ and $V_{C2} = V_{ref} - (V_L' + V_{th2})$ are maintained on the capacitors C1 and C2, respectively, without alteration. The voltages VC1 and VC2 are applied to the gate electrodes G1 and G2, respectively, during the sensing operation of the sense amplifier 11, as will now be described.

At the time t7, a sensing operation begins and, in response to turn on of an access transistor (not shown) at a selected line of the memory cell to be read, the electrical charge stored in a capacitative element of the selected memory cell appears as a sense voltage $V_s$ at the bit line BL1. In the present example, it is assumed that the bit stored in the memory cell is a digital "0", and so the voltage of the bit line BL1 is $V_{ref} - V_s$, as in the example described above in connection with the previously proposed sense amplifier 10. Similarly, the potential of the bit line BL2 is maintained at $V_{ref}$. As discussed above, if the bit stored in the memory cell were a digital "1" the voltage impressed on the bit line BL1 would be $V_{ref} + V_s$.

When the voltage $V_{ref} - V_s$ appears on the bit line BL1, the capacitor C2 cannot discharge through the transistor M2, which is maintained in its off state by the intermediate high voltage $V_H'$ of the control signal $\phi_s$ appearing at its source electrode SD22. Therefore, the voltage $V_{C2}$ cannot change to compensate for the change in the voltage on the bit line BL1 from $V_{ref}$ to $V_{ref} - V_s$, and so the voltage $V_B$ appearing at the gate electrode G2 must change instead. In particular,

$$V_B = V_{ref} - V_s - (V_{ref} - [V_L' + V_{th2}])$$

$$= V_L' + V_{th2} - V_s.$$

At the same time, the voltage on the bit line BL2 remains at $V_{ref}$, so that the voltage $V_A$ at the gate electrode G1 is

$$V_A = V_{ref} - [V_{ref} - (V_L' + V_{th1})]$$
$$= V_L' + V_{th1}.$$

In other words, the voltages $V_A$ and $V_B$ are higher than the voltages which would appear in the previously proposed sense amplifier 10 by the respective threshold voltages $V_{th1}$ and $V_{th2}$. Therefore, the gate to source voltages $V_{GS1}$ and $V_{GS2}$ which determine when the transistors M1 and M2 are respectively turned on are fully compensated by the respective threshold voltages $V_{th1}$ and $V_{th2}$, and the sense amplifier 11 has extremely high sensitivity.

Thus, when, at a time t8, the control signal $\phi_s$ is lowered from the intermediate high voltage $V_H'$ towards the low voltage $V_L$ to start the latching of the transistors M1 and M2, the gate to source voltage $V_{GS1}$ between the gate electrode G1 and the source electrode SD12 is given by

$$V_{GS1} = V_A - \phi_s$$
$$= V_L' + V_{th1} - \phi_{s'}$$

while the gate to source voltage $V_{GS2}$ between the gate electrode G2 and the source electrode SD22 of the transistor M2 is given by

$$V_{GS2} = V_B - \phi_s$$
$$= V_L' + V_{th2} - V_s - \phi_s.$$

It is readily apparent that the relationship
$V_{GS1} > V_{GS2}$
is equivalent to

$$V_A - \phi_s - V_{th1} > V_B - \phi_s - V_{th2}$$

which is in turn equivalent to

$$V_L' - \phi_s > V_L' - \phi_s - V_s$$

and holds for all values of the control signal $\phi_s$ from $V_H'$ to $V_L$. Therefore, the transistor M1 will always be turned on first and the effect of the dispersion of the threshold voltages $V_{th1}$ and $V_{th2}$ is compensated for. Thereafter, in a manner identical to the described operation of the known sense amplifier 10, when the transistor M1 is turned on the voltage at the drain electrode SD11 is pulled down to the low voltage $V_L$ as the control signal $\phi_s$ is reduced to that low voltage $V_L$, and the voltage $V_B$ is similarly lowered, since the transistor M2 remains off so that the capacitor C2 cannot discharge therethrough. Thus, the voltage appearing at the bit line BL1 is reduced to the low voltage $V_L$ while the voltage at the bit line BL2 is maintained at $V_{ref}$ to complete the latching operation.

The sense amplifier 11 accumulates, at the capacitors C1 and C2, precharged voltages corresponding to the threshold dispersion voltage $\Delta V_{th}$ of the threshold voltages $V_{th1}$ and $V_{th2}$ of the transistors M1 and M2, so that, during the sensing operation, this threshold dispersion voltage $\Delta V_{th}$ is compensated for completely. Consequently, a manufacturing process may be employed for providing large numbers of chips including sense amplifiers embodying the present invention on a single wafer with the assurance that even those sense amplifiers having significant threshold voltage dispersions will function acceptably. Therefore, the yield of such process, defined as the number of good chips on the wafer divided by the total number of chips on the wafer, will be increased. Furthermore, since the compensation for the threshold dispersion voltage $\Delta V_{th}$ is performed dynamically during each precharging operation prior to each sensing operation, the continuing accuracy of the sense amplifiers is not so heavily dependent upon precision in the manufacturing process, so that the sense amplifiers embodying the present invention have a high time dependent reliability, defined as the number of devices still operating acceptably after a period of time divided by the total number of devices originally produced.

Even when the capacitance within each memory cell is reduced, for example by a factor of 5 or 6, as further miniaturisation is achieved, reliable operation free of malfunction is available due to the high sensitivity of the sense amplifier embodying the present invention. Advantageously, an excellent result may be obtained by applying the sense amplifier embodying the present invention to a memory device fabricated using a silicon-on-insulator (SOI) structure.

Although the above description has been given for a preferred embodiment using NMOS technology, it will be apparent that an equivalent sense amplifier could be constructed using PMOS technology, with suitable inversion of the control signals and voltage reference levels in accordance with conventional principles.

## Claims

1. A sense amplifier (11) comprising:
   first and second bit lines (BL1, BL2) for receiving sensed signals;
   first and second cross-coupled field effect transistors (M1, M2) each having a gate electrode (G1, G2) and first and second current carrying electrodes (SD11, SD12, SD21, SD22);

capacitive means (C1, C2) for capacitively coupling the gate electrodes (G1, G2) of the first and second transistors (M1, M2) with the second and first bit lines (BL2, BL1), respectively;

first switching means (S11, S21) for separably connecting the gate electrodes (G1, G2) of the first and second transistors (M1, M2) with the first current carrying electrodes (SD11, SD21) of the first and second transistors (M1, M2), respectively; and

second switching means (S12, S22) for separably connecting the first current carrying electrodes (SD11, SD21) of the first and second transistors (M1, M2) with the first and second bit lines (BL1, BL2), respectively;

the first and second switching means (S11, S21, S12, S22) and the second current carrying electrodes (SD12, SD22) of the first and second transistors (M1, M2) being responsive to respective control signals ($\phi_1$, $\phi_2$, $\phi_s$) for compensating the sense amplifier (11) for any threshold voltage difference between the first and second transistors (M1, M2);

characterised in that the second switching means (S12, S22) is operable to connect the first current carrying electrodes (SD11, SD21) of the first and second transistors (M1, M2) directly to the first and second bit lines (BL1, BL2), respectively.

2. A sense amplifier according to claim 1, wherein the capacitive means (C1, C2) is operative to supply voltages ($V_{C1}$, $V_{C2}$) compensating for any dispersion ($\Delta V_{th)}$) between the threshold voltages ($V_{th1}$, $V_{th2}$) of the first and second transistors (M1, M2) to the gate electrodes (G1, G2) during a sensing operation of the sense amplifier (11).

3. A sense amplifier according to claim 2, wherein the first and second switching means (S11, S21, S12, S22) are responsive to the respective control signals ($\phi_1$, $\phi_2$) to precharge the capacitive means (C1, C2) to precharged voltages ($V_{C1}$, $V_{C2}$) prior to the sensing operation of the sense amplifier (11), the capacitive means (C1, C2) being operative to supply the precharged voltages ($V_{C1}$, $V_{C2}$) to the gate electrodes (G1, G2) during the sensing operation.

4. A sense amplifier according to claim 3, wherein the capacitive means (C1, C2) comprises a first capacitor (C1) connected between the gate electrode (G1) of the first transistor (M1) and the second bit line (BL2) and a second capacitor (C2) connected between the gate electrode (G2) of the second transistor (M2) and the first bit line (BL1).

5. A sense amplifier according to claim 3 or claim 4, wherein the second current carrying electrodes (SD12, SD22) of the first and second transistors (M1, M2) are coupled together to receive a common control signal ($\phi_s$) to permit or prevent turning on of the transistors (M1, M2), and wherein the precharged voltages ($V_{C1}$, $V_{C2}$) are determined such that, when the common control signal ($\phi_s$) permits turning on, the difference between the voltage ($V_A$) appearing at the gate electrode ($G_1$) of the first transistor (M1) and the threshold voltage ($V_{th1}$) thereof differs from the difference between the voltage ($V_B$) appearing at the gate electrode (G2) of the second transistor (M2) and the threshold voltage ($V_{th2}$) thereof by an amount equal to a sensed signal ($V_s$) appearing on a selected one of the bit lines (BL1, BL2), whereby a selected one of the first and second transistors (M1, M2) will always turn on before the other of the transistors (M1, M2) in dependence on the sensed signal ($V_s$).

**Patentansprüche**

1. Leseverstärker (11), der umfaßt:

erste und zweite Bitleitungen (BL1, BL2) zum Aufnehmen erfaßter Signale,

erste und zweite kreuzgekoppelte Feldeffekt-Transistoren (M1, M2), von denen jeder eine Gate-Elektrode (G1, G2) und erste und zweite stromführende Elektroden (SD11, SD12, SD21, SD22) hat,

kapazitive Elemente (C1, C2) zum kapazitiven Koppeln der Gate-Elektroden (G1, G2) der ersten und zweiten Transistoren (M1, M2) mit der zweiten bzw. der ersten Bitleitung (BL2, BL1),

ein erstes Schaltmittel (S11, S21) zum trennbaren Verbinden der Gate-Elektroden (G1, G2) der ersten und zweiten Transistoren (M1, M2) mit den ersten stromführenden Elektroden (SD11, SD21) des ersten bzw. des zweiten Transistors (M1, M2) und

ein zweites Schaltmittel (S12, S22) zum trennbaren Verbinden der ersten stromführenden Elektroden (SD11, SD21) der ersten und zweiten Transistoren (M1, M2) mit der ersten bzw. der zweiten Bitleitung (BL1, BL2),

wobei das erste und das zweite Schaltmittel (S11, S21, S12, S22) und die zweiten stromführenden Elektroden (SD12, SD22) der ersten und zweiten Transistoren (M1, M2) auf betreffende Steuersignale ($\phi_1$, $\phi_2$, $\phi_s$) zum Kompen-

sieren des Leseverstärkers (11) bezüglich jedweder Schwellspannungsdifferenz zwischen dem ersten und dem zweiten Transistor (M1, M2) ansprechen,

**dadurch gekennzeichnet,** daß das zweite Schaltmittel (S12, S22) betätigbar ist, um die ersten stromführenden Elektroden (SD11, SD21) der ersten und zweiten Transistoren (M1, M2) direkt mit der ersten bzw. der zweiten Bitleitung (BL1, BL2) zu verbinden.

2. Leseverstärker nach Anspruch 1, bei dem die kapazitiven Elemente (C1, C2) wirksam sind, um Spannungen ($V_{C1}$, $V_{C2}$), die jedwede Streuung ($\Delta V_{th}$) zwischen den Schwellspannungen ($V_{th1}$, $V_{th2}$) der ersten und zweiten Transistoren (M1, M2) kompensieren, während einer Leseoperation des Leseverstärkers (11) an die Gate-Elektroden (G1, G2) zu legen.

3. Leseverstärker nach Anspruch 2, bei dem die ersten und zweiten Schaltmittel (S11, S21, S12, S22) auf die betreffenden Steuersignale ($\phi_1$, $\phi_2$) ansprechen, um die kapazitiven Elemente (C1, C2) auf vorgeladene Spannungen ($V_{C1}$, $V_{C2}$) vor der Leseoperation des Leseverstärkers (11) vorzuladen, wobei die kapazitiven Elemente (C1, C2) wirksam sind, um die vorgeladenen Spannungen ($V_{C1}$, $V_{C2}$) während der Leseoperation an die Gate-Elektroden (G1, G2) zu legen.

4. Leseverstärker nach Anspruch 3, bei dem die kapazitiven Elemente (C1, C2) aus einem ersten Kondensator (C1), der zwischen die Gate-Elektrode (G1) des ersten Transistors (M1) und die zweite Bitleitung (BL2) geschaltet ist, und aus einem zweiten Kondensator (C2), der zwischen die Gate-Elektrode (G2) des zweiten Transistors (M2) und die erste Bitleitung (BL1) geschaltet ist, bestehen.

5. Leseverstärker nach Anspruch 3 oder 4, bei dem die zweiten stromführenden Elektroden (SD12, SD22) der ersten und zweiten Transistoren (M1, M2) zusammengeschaltet sind, um ein gemeinsames Steuersignal ($\phi_s$) aufzunehmen, um das Einschalten der Transistoren (M1, M2) zu gestatten oder zu verhindern, und bei dem die vorgeladenen Spannungen ($V_{C1}$, $V_{C2}$) derart bestimmt sind, daß sich, wenn das gemeinsame Steuersignal ($\phi_s$) ein Einschalten gestattet, die Differenz zwischen der Spannung ($V_A$), welche an der Gate-Elektrode (G1) des ersten Transistors (M1) auftritt, und der Schwellspannung ($V_{th1}$) desselben von der Differenz zwischen der Spannung ($V_B$), welche an der Gate-Elektrode (G2) des zweiten Transistors (M2) auftritt, und der Schwellspannung ($V_{th2}$) desselben um einen Betrag unterscheidet, der gleich einem erfaßten Signal ($V_s$) ist, welches auf einer Ausgewählten der Bitleitungen (BL1, BL2) auftritt, wodurch ein Ausgewählter der ersten und zweiten Transistoren (M1, M2) stets vor dem anderen der Transistoren (M1, M2) in Abhängigkeit von dem erfaßten Signal ($V_s$) eingeschaltet wird.

## Revendications

1. Amplificateur de lecture (11) comprenant :

des première et seconde lignes de bit (BL1, BL2) pour recevoir des signaux de lecture ;

des premier et second transistors à effet de champ couplés en croix (M1, M2) chacun comportant une électrode de grille (G1, G2) et des première et seconde électrodes de transport de courant (SD11, SD12, SD21, SD22) ;

un moyen capacitif (C1, C2) pour respectivement coupler de manière capacitive les électrodes de grille (G1, G2) des premier et second transistors (M1, M2) aux seconde et première lignes de bit (BL2, BL1) ;

un premier moyen de commutation (S11, S21) pour respectivement connecter de manière séparable les électrodes de grille (G1, G2) des premier et second transistors (M1, M2) aux premières électrodes de transport de courant (SD11, SD21) des premier et second transistors (M1, M2) ; et

un second moyen de commutation (S12, S22) pour respectivement connecter de manière séparable les premières électrodes de transport de courant (SD11, SD21) des premier et second transistors (M1, M2) aux première et seconde lignes de bit (BL1, BL2) ;

les premier et second moyens de commutation (S11, S21, S12, S22) et les secondes électrodes de transport de courant (SD12, SD22) des premier et second transistors (M1, M2) étant sensibles à des signaux de commande respectifs ($\Phi_1$, $\Phi_2$, $\Phi_S$) pour compenser pour l'amplificateur de lecture (11) toute différence de tension de seuil entre les premier et second transistors (M1, M2) ;

caractérisé en ce que le second moyen de commutation (S12, S22) peut fonctionner pour respectivement connecter les premières électrodes de transport de courant (SD11, SD21) des premier et second transistors (M1, M2) directement aux première et seconde lignes de bit (BL1, BL2).

2. Amplificateur de lecture selon la revendication 1, dans lequel le moyen capacitif (C1, C2) fonctionne pour appliquer des tensions ($V_{C1}$, $V_{C2}$) qui compensent toute dispersion ($\Delta V_{th}$) entre les tensions de seuil ($V_{th1}$, $V_{th2}$) des premier et second transistors (M1, M2) appliquées aux électrodes de grilles (G1, G2) pendant une opération de lecture de l'amplificateur de lecture (11).

3. Amplificateur de lecture selon la revendication 2, dans lequel les premier et second moyens de commutation (S11, S21, S12, S22) sont sensibles aux signaux de commande respectifs ($\Phi_1$, $\Phi_2$) afin de précharger les moyens capacitifs (C1, C2) à des tensions préchargées ($V_{C1}$, $V_{C2}$) avant l'opération de lecture de l'amplificateur de lecture (11), les moyens capacitifs (C1, C2) pouvant fonctionner pour appliquer les tensions préchargées ($V_{C1}$, $V_{C2}$) aux électrodes de grille (G1, G2) pendant l'opération lecture.

4. Amplificateur de lecture selon la revendication 3, dans lequel les moyens capacitifs (C1, C2) comprennent une première capacité (C1) connectée entre l'électrode de grille (G1) du premier transistor (M1) et la seconde ligne de bit (BL2) et une seconde capacité (C2) connectée entre l'électrode de grille (G2) du second transistor (M2) et la première ligne de bit (BL1).

5. Amplificateur de lecture selon la revendication 3 ou 4, dans lequel les secondes électrodes de transport de courant (SD12, SD22) des premier et second transistors (M1, M2) sont couplées ensemble pour recevoir un signal de commande commun ($\Phi_S$) afin de permettre ou d'empêcher le passage à l'état passant des transistors (M1, M2), et dans lequel les tensions préchargées ($V_{C1}$, $V_{C2}$) sont déterminées de telle sorte que, lorsque le signal de commande commun ($\Phi_S$) permet le passage à l'état passant, la différence entre la tension ($V_A$) qui apparait au niveau de l'électrode de grille ($G_1$) du premier transistor (M1) et la tension de seuil ($V_{th1}$) de celui-ci diffère de la différence entre la tension ($V_B$) qui apparaît au niveau de l'électrode de grille (G2) du second transistor (M2) et sa tension de seuil ($V_{th2}$) d'une quantité égale à un signal détecté ($V_S$) qui apparaît sur l'une sélectionnée des lignes de bit (BL1, BL2) et ainsi, l'un sélectionné des premier et second transistors (M1 M2) sera toujours passant avant l'autre des transistors (M1, M2) en fonction du signal détecté ($V_S$).

# FIG. 1

# FIG.2

(A) $\phi_1$ — $t_4$

(B) $\phi_2$ — $t_5$, $t_6$

(C) $\phi_r$

(D) $\phi_S$ — $V_H$, $V_{H'}$, $V_{L'}$, $t_3$, $V_L$

(E) $V_A$, $V_B$ — $V_{ref}$, $V_{L'} + V_{th1}$, $V_{L'} + V_{th2}$, $V_{L'} + V_{th2} - V_S$, $V_A$, $V_B$

(F) — $V_{ref}$, $BL_2$, $V_{ref} - V_S$, $V_L$, $BL_1$

$t_0$ $t_1$ $t_2$ ... $t_7$ $t_8$ ... $t$

## FIG.3

## FIG.4